# EUROPÄISCHE PATENTANMELDUNG

(11) **EP 4 372 790 A1**
(43) Veröffentlichungstag der Anmeldung: **22.05.2024**
(21) Anmeldenummer: 22208218.2
(22) Anmeldetag: 18.11.2022
(51) Int. Cl.: H01L 21/67, G01B 5/00, G05B 19/27, G05B 19/402, H01L 21/68, G03F 7/20

(54) **POSITIONIEREINRICHTUNG**

(71) Anmelder: Dr. Johannes Heidenhain GmbH, 83301 Traunreut (DE)
(72) Erfinder: Bakker, Arjan Franklin, 5759PX Helenaveen (NL); van Campen, Bart, 5655JE Eindhoven (NL)

(57) **Zusammenfassung**

Es wird eine Positioniereinrichtung zum Positionieren eines Tisches (SSM) relativ zu einem Werkzeug (T) offenbart, das an einer Trägervorrichtung (FAP) befestigt ist. Die Positioniereinrichtung umfasst zwei gekreuzte und in einer vertikalen Richtung (Z) übereinander angeordnete Linearachsen (LSX, LSY), zum Vorpositionieren des Tisches (SSM) in zwei voneinander linear unabhängigen Richtungen (X, Y), wobei der Tisch (SSM) mittels einer ersten Magnetschwebeeinheit (ML1) auf der einen der beiden Linearachsen (LSX) gehalten und zur Feinpositionierung in sechs Freiheitsgraden aktiv bewegbar ist. Die Position des Tisches (SSM) relativ zur Trägervorrichtung (FAP) ist über einen auf der anderen der beiden Linearachsen (LSY) angeordneten Messkopf (FMH) und einen ersten und zweiten 6-DOF Encoder (A, B) feststellbar, indem der erste 6-DOF Encoder (A) zwischen der Trägervorrichtung (FAP) und dem Messkopf (FMH) angeordnet ist, und der zweite 6-DOF Encoder (B) zwischen dem Messkopf (FMH) und dem Tisch (SSM) angeordnet ist. Der Messkopf (FMH) ist hierfür mittels einer zweiten Magnetschwebeinheit (ML2) auf der anderen der beiden Linearachsen (LSY) in sechs Freiheitsgraden aktiv bewegbar.

## Beschreibung

### GEBIET DER TECHNIK

Die vorliegende Erfindung betrifft eine Positioniereinrichtung, mit der beispielsweise ein Wafer auf einem Wafertisch sehr genau relativ zu einem an einer Trägervorrichtung montierten Objektiv eines Inspektionsapparates oder einer Belichtungsmaschine positioniert werden kann.

### STAND DER TECHNIK

Die Positionierung eines beweglichen Objektes in sechs Freiheitsgraden (in einem kartesischen Koordinatensystem sind das die drei aufeinander senkrecht stehenden linearen Raumrichtungen, hier mit X, Y, Z bezeichnet, und die drei Rotationen dX, dY und dZ um diese linearen Raumrichtungen) relativ zu einem ortsfesten Objekt ist eine immer wiederkehrende Aufgabe in der Technik. Um ein Objekt relativ zu einem anderen Objekt mittels geregelter Antriebe positionieren zu können, ist die Messung der relativen Position in allen Freiheitsgraden notwendig. Ein hierfür verwendetes Positionsmessgerät wird oft als Encoder bezeichnet und ist in sehr unterschiedlichen Ausführungsformen bekannt. Die Messung kann auf unterschiedlichsten physikalischen Prinzipien beruhen. So sind z.B. optische, magnetische, kapazitive oder induktive Strukturen auf einem der beiden Objekte bekannt, deren Abtastung mit einem zu den Strukturen passenden Abtastkopf Signale liefert, aus denen die gewünschte Positionsinformation gewonnen werden kann. Je nach Encoder lassen sich Positionsinformationen für mindestens einen, mehrere oder alle sechs Freiheitsgrade gewinnen.

Die EP 1019669 B1 liefert ein Beispiel für einen Encoder, der eine Information für die Position eines Objektes relativ zu einem anderen Objekt angeben kann. Hierfür trägt das eine Objekt einen Maßstab mit einem Kreuzgitter. Das andere Objekt trägt einen Abtastkopf mit drei Abtastungen für zwei lineare Raumrichtungen in der Ebene des Maßstabs (in-plane Freiheitsgrade), aus denen auch die Rotation um die dritte Raumrichtung (out-of-plane Freiheitsgrad, hier senkrecht zur Ebene des Maßstabs) gewonnen werden kann. Im Abtastkopf finden sich außerdem drei Abstandssensoren, die jeweils Positionswerte bezüglich des out-of-plane Freiheitsgrads liefern und damit die Bestimmung des out-of-plane Freiheitsgrads und die Rotationen um die in-plane Freiheitsgrade ermöglichen.

Die US 9979262 B2 beschreibt eine Positioniereinrichtung für einen Wafertisch, der auf dem Querbalken einer Gantry-Anordnung montiert ist. Wegen der für den Durchsatz notwendigen hohen Beschleunigungen des Wafertisches ist der Querbalken großen Kräften ausgesetzt und als Referenz für Positionsmessungen nicht gut geeignet. Es wird daher ein zweiter Querbalken ohne Wafertisch mitgeführt, der wegen seiner geringeren Masse besser als Positionsreferenz geeignet ist. Mit einem ersten Encoder wird die Position des Wafertisches relativ zum zweiten Querbalken erfasst, mit einem zweiten Encoder die Position des zweiten Querbalkens zur ortsfesten Referenz. Für die Encoder kommen jeweils mehrere Abtastköpfe und mehrere Maßstäbe zum Einsatz, so dass die Positionen jeweils in allen sechs Freiheitsgraden bestimmt werden können. So ein Encoder wird hier auch als 6-DOF Encoder bezeichnet. Der zweite Querbalken dient also als bewegliche Referenzstruktur, über die mittels zweier Encoder die Position des Wafertisches relativ zur ortsfesten Referenz ermittelt werden kann.

Die EP 1762828 B1 beschreibt einen Abtastkopf, dessen Abtastoptik aus der Abtastung eines optischen Gitters sowohl einen in-plane Freiheitsgrad (in der Gitterebene) als auch einen out-of-plane Freiheitsgrad (senkrecht zur Gitterebene) messen kann. Beide Dimensionen können dabei mit sehr hoher Genauigkeit im sub-Nanometer Bereich gemessen werden. Durch eine Kombination unterschiedlich ausgerichteter Abtastköpfe dieser Art kann ein 6-DOF Encoder für die Positionsmessung in sechs Freiheitsgraden gebildet werden, wie es in der Figur 2 dieses Dokuments dargestellt ist.

Die EP 1715384 B1 beschreibt eine Positioniereinrichtung für einen Wafer. Der Wafertisch ist auf einer Magnetschwebeeinheit angeordnet, die den Tisch in sechs Freiheitsgraden positionieren kann, allerdings nur mit kleinen Bewegungen. Für große Verschiebungen in einer horizontalen Ebene parallel zur Aufstellebene sind zwei gekreuzte Linearachsen unter dem Wafertisch angeordnet, von denen die obere die Magnetschwebeeinheit trägt. Die Positionierung des Wafertisches relativ zu einem ortsfesten Werkzeug wie der Linse eines Belichtungsapparates erfolgt, indem mit einem ersten 6-DOF Encoder die Position des Wafertisches relativ zu einem mitbewegten Messkopf erfasst wird, und mit einem zweiten 6-DOF Encoder die Position des Messkopfes relativ zum ortsfesten Werkzeug. Der mitbewegte Messkopf ist auf der unteren der beiden gekreuzten Linearachsen angeordnet und bleibt so in der Nähe des Wafertisches, wenn der Wafertisch mit der unteren Linearachse verschoben wird. Auch wenn die Bewegungen mit den gekreuzten Linearachsen nicht zu entsprechend großen Änderungen im Abtastabstand der beiden 6-DOF Encoder führt, so sind diese Änderungen z.B. aufgrund von Führungsfehlern immer noch zu groß, um sehr genaue Positionen zu bestimmen. Zwar ist es bis zu einem gewissen Grad möglich, beispielsweise die Auswirkung der Änderungen des Abtastabstandes in den 6-DOF Encodern oder die Verkippung der Abtastköpfe gegenüber den Maßstäben anhand eines Encoder-Modells zu modellieren oder zu kalibrieren, doch ist eine hochgenaue Positionsauswertung in dieser Anordnung schwierig und der Aufwand dafür sehr hoch, oder kann bei zu großen Schwankungen scheitern.

### ZUSAMMENFASSUNG DER ERFINDUNG

Es ist daher Aufgabe der Erfindung, eine Positioniereinrichtung anzugeben, mit der ein Tisch relativ zu einem Werkzeug mit weiter erhöhter Genauigkeit positioniert werden kann, indem die Positionserfassung des Tisches relativ zum Werkzeug weiter verbessert wird.

Diese Aufgabe wird gelöst durch eine Vorrichtung gemäß Anspruch 1. Vorteilhafte Details dieser Vorrichtung und ein Verfahren zum Betreiben dieser Vorrichtung ergeben sich auch aus den von Anspruch 1 abhängigen Ansprüchen.

Es wird eine Positioniereinrichtung zum Positionieren eines Tisches relativ zu einem Werkzeug offenbart, das an einer Trägervorrichtung befestigt ist. Die Positioniereinrichtung umfasst zwei gekreuzte und in einer vertikalen Richtung übereinander angeordnete Linearachsen, zum Vorpositionieren des Tisches in zwei voneinander linear unabhängigen Richtungen, wobei der Tisch mittels einer ersten Magnetschwebeeinheit auf der einen der beiden Linearachsen gehalten und zur Feinpositionierung in sechs Freiheitsgraden aktiv bewegbar ist. Die Position des Tisches relativ zur Trägervorrichtung ist über einen auf der anderen der beiden Linearachsen angeordneten Messkopf und einen ersten und zweiten 6-DOF Encoder feststellbar, indem der erste 6-DOF Encoder zwischen der Trägervorrichtung und dem Messkopf angeordnet ist, und der zweite 6-DOF Encoder zwischen dem Messkopf und dem Tisch angeordnet ist. Der Messkopf ist hierfür mittels einer zweiten Magnetschwebeeinheit auf der anderen der beiden Linearachsen in sechs Freiheitsgraden aktiv bewegbar.

Indem nun auch der zwischen dem Tisch und der Trägervorrichtung angeordnete Messkopf auf einer Magnetschwebeeinheit angeordnet ist, kann der Messkopf bis auf die gewollten Bewegungen in den beiden Linearachsen alle anderen ungewollten Bewegungen kompensieren. Die beiden 6-DOF Encoder können dank der nun wesentlich geringeren Schwankungen im Abtastabstand bzw. in den Verkippungen genauer messen, bzw. der Aufwand für Kalibrierung und Modellierung sinkt erheblich.

Weitere Vorteile und Einzelheiten der vorliegenden Erfindung ergeben sich aus der nachfolgenden Beschreibung verschiedener Ausführungsformen anhand der Figuren.

### KURZE BESCHREIBUNG DER ZEICHNUNGEN

Dabei zeigen
- Figur 1: ein Schema einer aus dem Stand der Technik bekannten Positioniereinrichtung,
- Figur 2: ein Schema einer Positioniereinrichtung gemäß der Erfindung,
- Figur 3: eine konkrete Ausgestaltung einer Positioniereinrichtung gemäß der Erfindung,
- Figuren 4, 5: Details der Anordnung der 6-DOF Encoder aus der Figur 3 in verschiedenen Ansichten,
- Figur 6: Details der Abtastköpfe der 6-DOF Encoder der Figur 3, und
- Figur 7: Details der Maßstäbe der 6-DOF Encoder der Figur 3.

### BESCHREIBUNG DER AUSFÜHRUNGSFORMEN

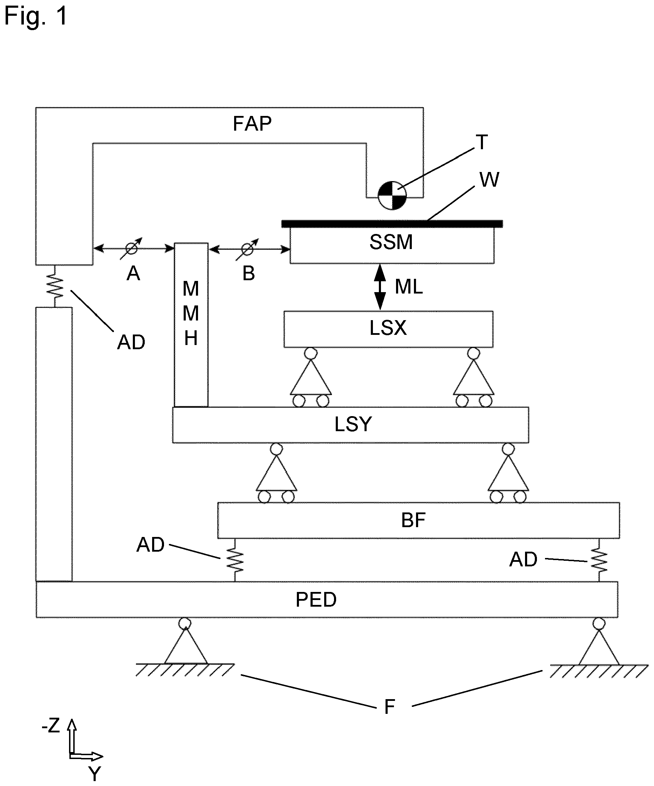

Die Figur 1 zeigt sehr schematisch eine Positioniereinrichtung, die nach aus dem Stand der Technik bekannten Prinzipien aufgebaut ist und die kein Ausführungsbeispiel der vorliegenden Erfindung ist.

Auf einem Sockel PED, der selbst beispielsweise auf dem Boden F einer Maschinenhalle oder eines Reinraums steht, ist ein Grundgestell BF mittels aktiver Dämpfer AD schwingungsisoliert aufgestellt. Das Grundgestell BF trägt gekreuzte Linearachsen LSY und LSX, die übereinander angeordnet sind, und die einen Tisch SSM zur Ablage eines Wafers W in den Richtungen X und Y parallel zum Boden F bewegen können, um jeden Punkt auf dem Wafer W mit dem Werkzeug T erreichen zu können.

Der Tisch SSM ist dabei auf einer Magnetschwebeeinheit ML angeordnet, die wiederum auf der oberen Linearachse LSX befestigt ist. Die Magnetschwebeeinheit ML kann den Tisch in allen sechs Freiheitsgraden um kleine Beträge auslenken und dient der Feinpositionierung, auch in der Z-Richtung, für die sonst keine Aktoren vorhanden sind. Alle rotatorischen Freiheitsgrade dX, dY, dZ sind ebenfalls über die Magnetschwebeeinheit ML in gewissem Maße einstellbar. Ein beweglicher Messkopf MMH bewegt sich mit der unteren Linearachse LSY in Y-Richtung mit. Bei solchen Bewegungen in Y-Richtung ändert sich der Abstand zwischen dem beweglichen Messkopf MMH und dem Tisch SSM nicht, bzw. es entstehen nur kleine Bewegungen durch mechanische Fehler in der Anordnung. Ein 6-DOF Encoder B misst die Relativposition zwischen dem beweglichen Messkopf MMH und dem Tisch SSM in allen sechs Freiheitsgraden. Bewegungen der oberen Linearachse LSX (senkrecht zur Ebene der Zeichnung) können vom Encoder B erfasst werden, wenn Maßstäbe des Encoders B entlang der Kante des Tisches SSM senkrecht zur Ebene der Zeichnung lang genug sind.

Auf dem Sockel PED ist außerdem mittels eines weiteren aktiven Dämpfers AD schwingungsisoliert eine Trägervorrichtung FAP angebracht, die ein Werkzeug T trägt, mit dem ein Wafer W bearbeitet werden soll. Dabei kann es sich um eine Linse zur Belichtung oder Inspektion des Wafers W handeln. In jedem Fall muss der Wafer W sehr genau relativ zum Werkzeug T positioniert werden. Hierfür misst ein weiterer 6-DOF Encoder A alle sechs Freiheitsgrade der Bewegung zwischen der Trägervorrichtung FAP und des beweglichen Messkopfes MMH. Addiert man nun die Messungen der beiden Encoder A und B, erhält man die Position des Tisches SSM relativ zur Trägervorrichtung FAP und damit auch zum Werkzeug T.

Die Trägervorrichtung FAP bewegt sich allerdings auf der aktiven Dämpfungseinrichtung AD gegenüber dem Podest PED vergleichsweise frei und entkoppelt vom restlichen Aufbau. Insbesondere der Encoder A muss daher große Schwankungen bezüglich des Abtastabstandes und der Verkippung seiner Abtastköpfe gegenüber den Maßstäben auf dem Messkopf MMH ausgleichen können. Dies bedeutet einen hohen Aufwand für die Kalibrierung eines Encoder-Modells und einen hohen Rechenaufwand. Werden gewisse Grenzen überschritten, erhält man auch keine genaue Messung mehr.

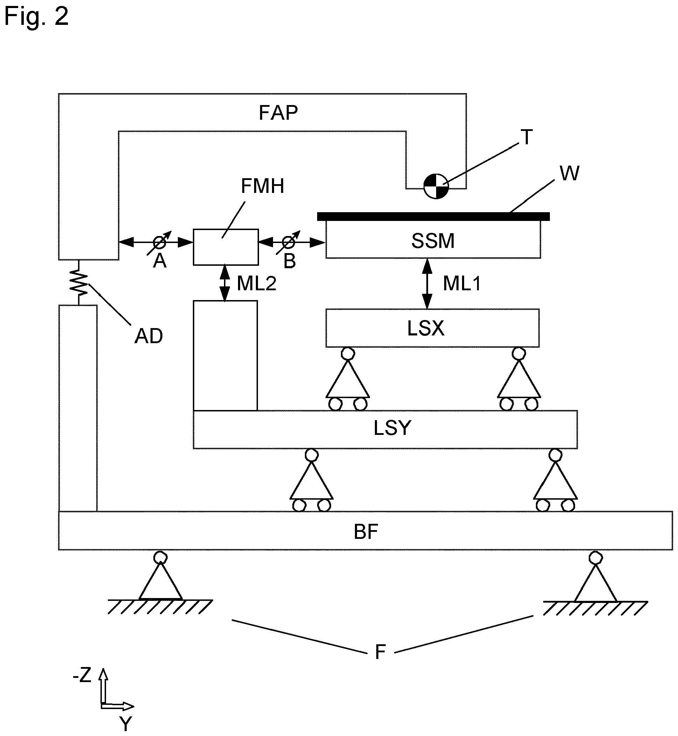

In der Figur 2 ist daher eine in einem entscheidenden Detail verbesserte Positioniereinrichtung gemäß der vorliegenden Erfindung gezeigt, bei der das genannte Problem in deutlich geringerem Maße auftritt.

Zunächst ist vereinfachend das Grundgestell BF unmittelbar auf dem Boden F angeordnet. Die zuvor in Figur 1 gezeigte Anordnung auf einem Podest PED stellt aber eine alternative Ausführungsform der Erfindung dar. Die Anordnung der beiden Linearachsen LSX und LSY sowie einer ersten Magnetschwebeeinrichtung ML1 und des Tisches SSM ist gegenüber der Figur 1 nicht verändert. Wieder ist die Trägervorrichtung FAP mit dem Werkzeug T über eine aktive Dämpfungseinrichtung AD vom Untergrund (hier vom Grundgestell BF) entkoppelt.

Der entscheidende Unterschied zur in Figur 1 gezeigten Anordnung liegt in der Tatsache, dass der Messkopf FMH nun ebenfalls von einer zweiten Magnetschwebeeinheit ML2 getragen wird. Dies ermöglicht es, die vom 6-DOF Encoder A festgestellte Relativbewegung zwischen der Trägervorrichtung FAP und dem Messkopf FMH zu erfassen und über eine geeignete Ansteuerung der zweiten Magnetschwebeeinheit ML2 auszugleichen. Dadurch werden die Schwankungen im Abtastabstand und in den Verkippungen der Abtastköpfe des 6-DOF Encoders A gegenüber den Maßstäben an der Trägervorrichtung FAP minimiert und die Messung erheblich vereinfacht bzw. deren Genauigkeit entscheidend gesteigert.

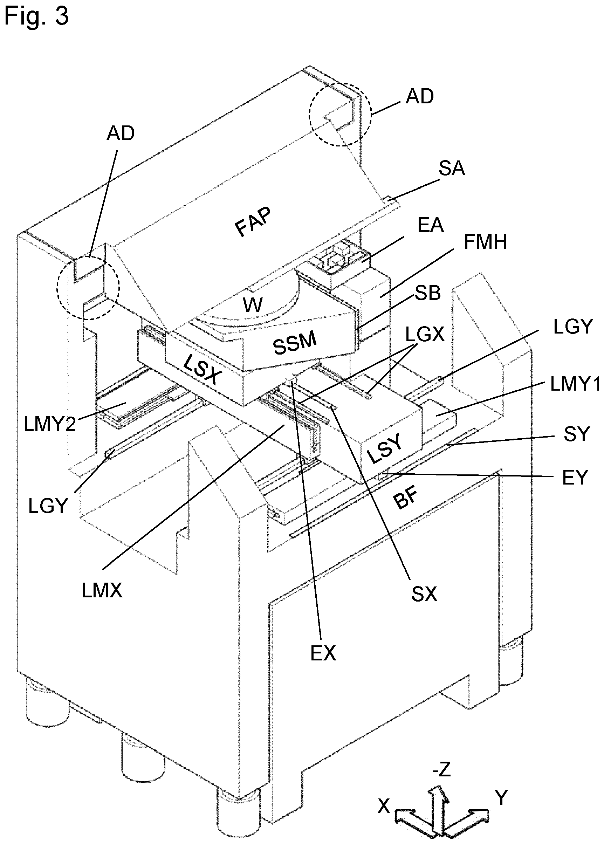

Da das jeweilige Messkonzept in den Figuren 1 und 2 nur sehr schematisch dargestellt ist, soll mit der Figur 3 ein konkretes Ausführungsbeispiel der Erfindung erklärt werden. Die Figur 3 zeigt eine Positioniereinrichtung mit teilweise entfernten Bereichen, um einen Blick auf deren inneren Aufbau zu gewähren.

In der Figur 3 sind auf dem Grundgestellt BF wieder gekreuzte Linearachsen LSY und LSX zu erkennen. Diese werden von je zwei Linearführungen LGY, LGX beweglich gehalten und von Linearmotoren LMY1, LMY2 und LMX angetrieben. Für diese Linearachsen LSY, LSX stehen Encoder EY, EX zur Verfügung, deren Abtastköpfe Linearmaßstäbe SY und SX abtasten. Somit können die Linearachsen LSY, LSX von einer übergeordneten Steuerung positioniert werden.

Zwischen dem Tisch SSM (mit darauf abgelegtem Wafer W) und der oberen Linearachse LSX befindet sich die erste Magnetschwebeeinheit ML1, die in dieser Figur 3 nicht erkennbar ist. Der Messkopf FMH wird über eine ebenfalls nicht dargestellte zweite Magnetschwebeinheit ML2 mit der unteren Linearachse LSY mitbewegt. Diese zweite Magnetschwebeeinheit ML2 ermöglicht Ausgleichsbewegungen des Messkopfes FMH in sechs Freiheitsgraden.

Die Trägervorrichtung FAP mit dem hier nicht dargestellten Werkzeug T ist über aktive Dämpfungseinrichtungen AD beidseitig mit dem Grundgestell BF verbunden. Die durch diese beiden Dämpfungseinrichtungen AD ermöglichten Bewegungen der Trägervorrichtung FAP führen zu den erwähnten Bewegungen zwischen der Trägervorrichtung FAP und den Abtastköpfen EA des 6-DOF Encoders A, die mit der zweiten Magnetschwebeeinheit ML2 kompensiert werden können.

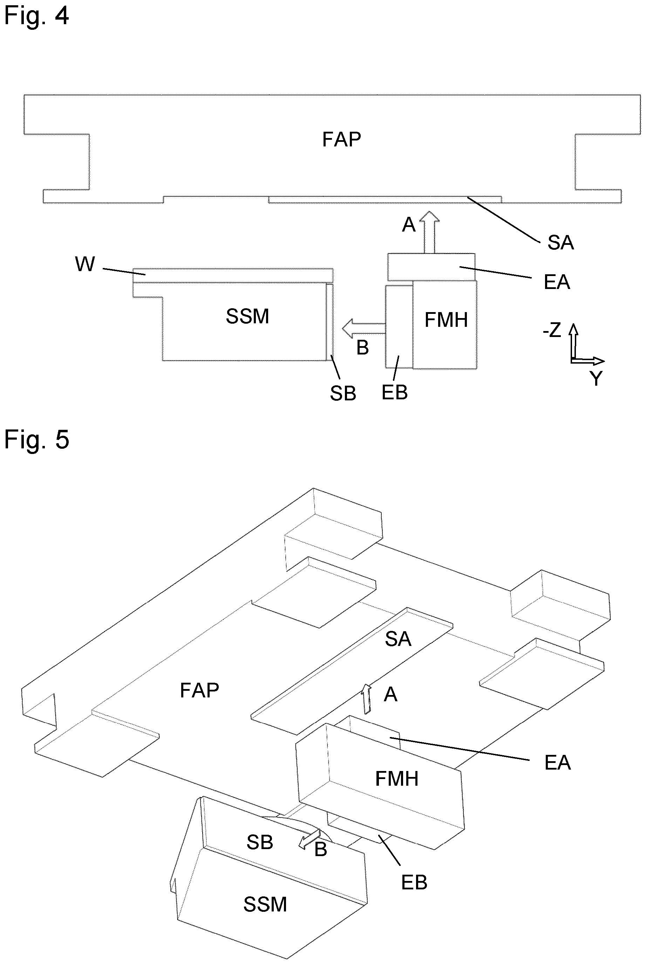

Die Figuren 4 und 5 erleichtern es, die Anordnung der 6-DOF Encoder A, B in der Zusammenschau mit der Figur 3 zu erkennen. Hierzu sind in den Figuren 4 und 5 nur die relevanten Teile der Anordnung aus Figur 3 in verschiedenen Ansichten gezeigt.

Auf unterschiedlichen Seitenflächen des Messkopfes FMH sind Abtastköpfe oder Abtastkopfgruppen EA, EB der 6-DOF Encoder A, B zu erkennen. Die Abtastköpfe EA sind dabei auf einen oder mehrere Maßstäbe SA ausgerichtet, die an der Trägervorrichtung FAP befestigt sind. Die Abtastköpfe EA und die Maßstäbe SA bilden zusammen den 6-DOF Encoder A. Eine mögliche Ausgestaltung dieser Maßstäbe SA und Abtastköpfe EA wird weiter unten erklärt.

Die Abtastköpfe EB des 6-DOF Encoders B sind auf einen oder mehrere Maßstäbe SB am Tisch SSM ausgerichtet. Die Abtastköpfe EB und die Maßstäbe SB bilden zusammen den 6-DOF Encoder B.

Bei geeigneter Anordnung der Maßstäbe SA, SB und der Abtastköpfe EA, EB können also die 6-DOF Encoder A, B jeweils eine Positionsbestimmung in sechs Freiheitsgraden liefern.

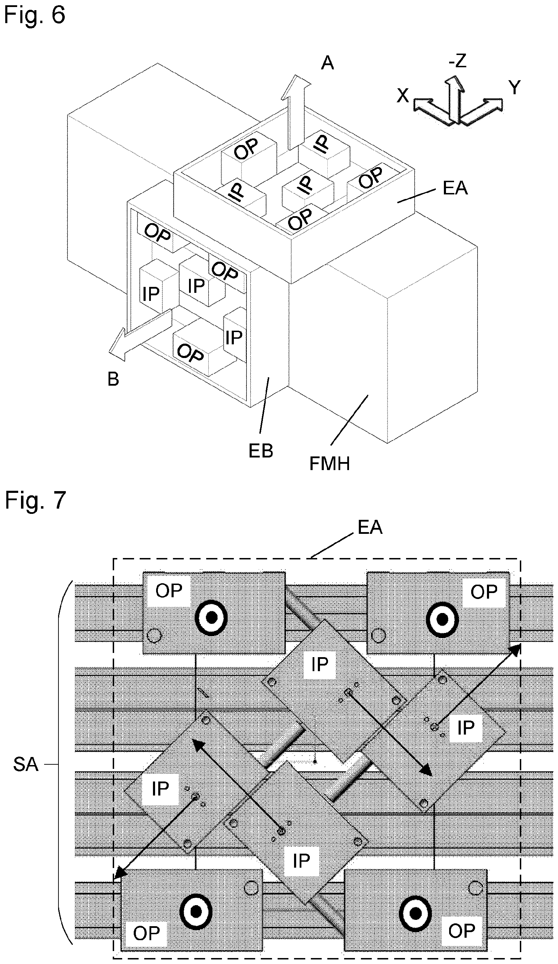

Die Figur 6 zeigt isoliert den Messkopf FMH und die daran angeordneten Abtastkopfgruppen EA, AB. Jede der Abtastkopfgruppen EA, EB umfasst mehrere Abtastköpfe IP, OP, die entweder in Richtungen parallel zu den Maßstäben (in-plane) oder senkrecht dazu (out-of-plane) messen können. Wie einleitend erklärt, sind auch Abtastköpfe bekannt, die Komponenten in beide Richtungen messen können. Die Anzahl der Abtastköpfe IP, OP einer Abtastkopfgruppe EA, EB und deren Messrichtungen müssen jedenfalls zusammen die Messung von sechs Freiheitsgraden zwischen dem Messkopf FMH und dem Tisch SSM (6-DOF Encoder B) bzw. zwischen dem Messkopf FMH und der Trägervorrichtung FAP (6-DOF Encoder A) ermöglichen.

In der Figur 7 ist eine Abtastkopfgruppe EA dargestellt, mit mehreren Abtastköpfen IP, OP, die eine Mehrzahl von parallelen Maßstäben SA abtasten. Um alle sechs Freiheitsgrade erfassen zu können, sind die Abtastköpfe IP, die parallel zur Ebene der Maßstäbe SA messen, gegeneinander verdreht. Die Abtastköpfe OP, die senkrecht zur Ebene der Maßstäbe SA messen können, sitzen in den Ecken der Abtastkopfgruppe EA, um einen maximalen Abstand voneinander zu haben und dadurch Verkippungen zwischen den Abtastköpfen IP, OP und der Ebene der Maßstäben SA genauer messen zu können. Weder die Abtastköpfe IP noch die Abtastköpfe OP dürfen auf einer Linie liegen, um alle sechs Freiheitsgrade bestimmen zu können.

Die Maßstäbe SA, SB können separate Elemente sein, oder unmittelbar auf die Bestandteile der Positioniereinrichtung geschriebene Markierungen. Wegen der erzielbaren hohen Genauigkeit sind optische Strukturen auf den Maßstäben bevorzugt, es sind aber alle aus dem eingangs zitierten Standes der Technik bekannten Prinzipien zur Herstellung von Maßstäben auch hier möglich.

Anstelle mehrerer paralleler Maßstäbe SA könnte auch eine Kreuzgitterplatte eingebaut werden. Mit Abtastköpfen EA, die sowohl in-plane als auch out-of-plane messen können, ließe sich die gestellte Messaufgabe schon mit drei Abtastköpfen erfüllen.

Mit der in den Figuren 3 bis 7 gezeigten Anordnung und deren erwähnten Ausgestaltungen ist es also möglich, die Position des Tisches SSM relativ zum Werkzeug T an der Trägervorrichtung FAP sehr genau zu messen, indem diese Messung auf zwei Positionsmessungen jeweils relativ zum Messkopf FMH aufgeteilt wird. Dank der zweiten Magnetschwebeeinheit ML2 kann der Messkopf FMH so angesteuert werden, dass die Messungen der Position zur Trägervorrichtung FAP sehr genau bleibt, auch wenn die Trägervorrichtung FAP von den aktiven Dämpfungseinrichtungen AD bewegt wird.

Ein mögliches Konzept zur Ansteuerung der Positioniereinrichtung besteht darin, über die zweite Magnetschwebeeinrichtung ML2 alle unerwünschten Bewegungen zwischen dem Messkopf FMH und der Trägervorrichtung FAP auszugleichen. Der Messkopf FMH folgt also stets der Trägervorrichtung FAP, außer im Falle einer erwünschten (von einer übergeordneten Steuerung vorgegebenen) Bewegung des Tisches SSM in Y-Richtung. Außerdem folgt der Tisch SSM über seine erste Magnetschwebeinrichtung ML1 stets dem Messkopf FMH, außer im Falle einer erwünschten (von der übergeordneten Steuerung vorgegebenen) Bewegung des Tisches in X-Richtung.

Ein alternatives Konzept der Ansteuerung der ersten Magnetschwebeeinheit ML1 der Positioniereinrichtung ist es, die festgestellten Positionswerte der beiden 6-DOF Encoder A, B zu addieren und den Tisch SSM damit unmittelbar der Trägervorrichtung FAP folgen zu lassen (bis auf die vorgegebenen Bewegungen in X und Y). Der Messkopf folgt dabei weiterhin wie zuvor ebenfalls der Trägervorrichtung FAP. Dies reduziert etwas die Anforderungen an die Ansteuerung der zweiten Magnetschwebeeinheit ML2 und verteilt die Fehler besser auf beide 6-DOF Encoder. Allerdings ist die Addition der Positionswerte nicht einfach, da die beiden 6-DOF Encoder A, B ihre gegenseitige Ausrichtung ständig ändern, und diese Änderung bei der Addition berücksichtigt werden muss. Vor allem gegenseitige Verkippungen führen dabei zu erheblichem Rechenaufwand.

Die Magnetschwebeeinrichtungen ML1, ML2 können nach bekannten Prinzipien wie Lorentz- oder Reluktanz - Aktuatoren oder Kombinationen aus beiden sein. Sie können in bekannter Weise schwerkraftkompensiert sein und/oder eine sehr geringe bis verschwindende Steifheit aufweisen, also (nahezu) kräftefrei verschiebbar sein.

Wenn hier von Positionsmessungen die Rede ist, kann damit eine absolute oder eine relative Positionsmessung bzw. die Messung von Positionsänderungen gemeint sein. So trägt z.B. ein Wafer W meist spezielle Justiermarken, um seine absolute Position relativ zum Werkzeug T festzustellen. Um die Positioniereinrichtung mittels einer übergeordneten Steuerung anzusteuern, genügen dann relative Positionsmessungen mit den 6-DOF Encodern A, B. Absolute Positionsmessungen sind aber über geeignet codierte Maßstäbe SA, SB ebenfalls möglich.

## Patentansprüche

1. Positioniereinrichtung zum Positionieren eines Tisches (SSM) relativ zu einem Werkzeug (T), das an einer Trägervorrichtung (FAP) befestigt ist, wobei die Positioniereinrichtung zwei gekreuzte und in einer vertikalen Richtung (Z) übereinander angeordnete Linearachsen (LSX, LSY) umfasst, zum Vorpositionieren des Tisches (SSM) in zwei voneinander linear unabhängigen Richtungen (X, Y), wobei der Tisch (SSM) mittels einer ersten Magnetschwebeeinheit (ML1) auf der einen der beiden Linearachsen (LSX) gehalten und zur Feinpositionierung in sechs Freiheitsgraden aktiv bewegbar ist, wobei die Position des Tisches (SSM) relativ zur Trägervorrichtung (FAP) über einen auf der anderen der beiden Linearachsen (LSY) angeordneten Messkopf (FMH) und einen ersten und zweiten 6-DOF Encoder (A, B) feststellbar ist, indem der erste 6-DOF Encoder (A) zwischen der Trägervorrichtung (FAP) und dem Messkopf (FMH) angeordnet ist, und der zweite 6-DOF Encoder (B) zwischen dem Messkopf (FMH) und dem Tisch (SSM) angeordnet ist, **dadurch gekennzeichnet, dass** der Messkopf (FMH) mittels einer zweiten Magnetschwebeinheit (ML2) auf der anderen der beiden Linearachsen (LSY) in sechs Freiheitsgraden aktiv bewegbar ist.

2. Positioniereinrichtung nach Anspruch 1, **dadurch gekennzeichnet, dass** der erste und zweite 6-DOF Encoder (A, B) jeweils auf Seitenflächen des Messkopfes (FMH) angeordnete Abtastkopfgruppen (EA, EB) mit Abtastköpfen (IP, OP) umfassen, die im Falle des ersten 6-DOF Encoders (A) auf wenigstens einen an der Trägervorrichtung (FAP) angeordneten ersten Maßstab (SA) ausgerichtet sind, und im Falle des zweiten 6-DOF Encoders (B) auf wenigstens einen am Tisch (SSM) angeordneten zweiten Maßstab (SB) ausgerichtet sind.

3. Positioniereinrichtung nach Anspruch 2, **dadurch gekennzeichnet, dass** die Abtastkopfgruppen (EA, EB) jeweils Abtastköpfe (IP, OP) umfassen, die eine Positionsmessung parallel zu einer Ebene der jeweils abgetasteten ersten und zweiten Maßstäbe (SA, SB) und senkrecht dazu ermöglichen.

4. Positioniereinrichtung nach Anspruch 3, **dadurch gekennzeichnet, dass** die Abtastköpfe (IP, OP) in den Abtastkopfgruppen (EA, EB) so angeordnet sind, dass Verkippungen in der Ebene der jeweils abgetasteten ersten und zweiten Maßstäbe (SA, SB) und eine Verdrehung um ein Lot auf die Ebene der jeweils abgetasteten ersten und zweiten Maßstäbe (SA, SB) erfassbar sind.

5. Positioniereinrichtung nach einem der vorhergehenden Ansprüche, **dadurch gekennzeichnet, dass** die gekreuzten Linearachsen (LSX, LSY) auf einem Grundgestell (BF) aufgebaut sind, und dass zwischen der Trägervorrichtung (FAP) und dem Grundgestell (BF) eine Dämpfungseinrichtung (AD) zur Reduzierung der Übertragung von Schwingungen angeordnet ist.

6. Positioniereinrichtung nach einem der vorhergehenden Ansprüche, **dadurch gekennzeichnet, dass** das Werkzeug (T) ein Objektiv einer Kamera oder einer Belichtungsvorrichtung ist.

7. Positioniereinrichtung nach einem der vorhergehenden Ansprüche, **dadurch gekennzeichnet, dass** der Tisch (SSM) ein Wafertisch ist.

8. Verfahren zum Betreiben einer Positioniereinrichtung nach einem der vorhergehenden Ansprüche, **dadurch gekennzeichnet, dass** die erste und zweite Magnetschwebeeinheiten (ML1, ML2) von einer übergeordneten Steuerung so angesteuert werden, dass der Messkopf (FMH) der Trägervorrichtung (FAP) folgt, indem die vom ersten Encoder (A) gemessenen Werte konstant gehalten werden, und dass der Tisch (SSM) entweder dem Messkopf (FMH) folgt, indem die vom zweiten Encoder (B) gemessenen Werte konstant gehalten werden, oder dass der Tisch (SSM) der Trägervorrichtung (FAP) folgt, indem die Summe der vom ersten und zweiten Encoder (A, B) gemessenen Werte konstant gehalten wird, und somit unerwünschte Abweichungen der Position des Tisches (SSM) relativ zum Werkzeug (T) kompensiert werden.

9. Verfahren nach Anspruch 8, wobei eine von der übergeordneten Steuerung angeordnete Positionsänderung des Tisches (SSM) relativ zum Werkzeug (T) nicht kompensiert wird.
